# EUROPEAN PATENT APPLICATION

(11) **EP 4 586 750 A1**
(43) Date of publication of application: **16.07.2025**
(21) Application number: 23862056.1
(22) Date of filing: 19.07.2023
(51) Int. Cl.: H05K 5/02

(54) **DECORATIVE SUBSTRATE, PREPARATION METHOD THEREFOR AND APPLICATION THEREOF**

(30) Priority: 06.09.2022 CN 202211088106
(71) Applicant: BYD Company Limited, Shenzhen, Guangdong 518118 (CN)
(72) Inventor: ZHU, Qiyu, Shenzhen, Guangdong 518118 (CN); ZHAO, Lihong, Shenzhen, Guangdong 518118 (CN); LUO, Wenhai, Shenzhen, Guangdong 518118 (CN); DUAN, Feifei, Shenzhen, Guangdong 518118 (CN); ZHAO, Fei, Shenzhen, Guangdong 518118 (CN)
(74) Representative: Schott, Jakob Valentin
(86) International application number: PCT/CN2023/108206
(87) International publication number: WO 2024/051355

(57) **Abstract**

A decorative substrate includes a base material, and a texture layer arranged on the base material. A plurality of grating grids are arranged on a surface on the side of the texture layer from the base material. At least the plurality of grating grids includes a plurality of grating units annularly arranged around a central point. Each grating unit includes a plurality of strip-shaped protrusions. The plurality of strip-shaped protrusions are sequentially arranged in the radius direction of a circle with the central point as its center. In the grating grids, each strip-shaped protrusion includes a first surface close to the central point, and a second surface away from the central point. The first surface and the second surface are connected to a third surface of the strip-shaped protrusion. An included angle formed by the first surface and the third surface of the strip-shaped protrusion is less than or equal to an included angle formed by the second surface and the third surface of the strip-shaped protrusion.

## Description

The present disclosure claims the priority of the Chinese Patent Application filed with the China Patent Office on September 6, 2022, with the application number 202211088106.2 and the application title "DECORATIVE SUBSTRATE, PREPARATION METHOD THEREFOR AND APPLICATION THEREOF", and the entire content of which is incorporated herein by reference.

### Technical Field

The present disclosure relates to the field of decoration technology, specifically to a decorative substrate, and a preparation method and application thereof.

### Background Technology

Currently, the textures and colors of the housing components of electronic devices, such as the back covers of mobile phones, are usually achieved through the decorative layer attached to the surface of the cover plate. However, the appearance of the decorative cover plates in the market is relatively monotonous at present, which cannot meet people's personalized needs and leads to weak competitiveness of products.

### Summary of the Invention

To solve the above problems, the present disclosure provides a decorative substrate. Through the texture layer with a specific structure, this decorative substrate can achieve a three-dimensional woven grid pattern effect similar to that of fabric, thus presenting a good decorative effect.

The first aspect of the present disclosure provides a decorative substrate. The decorative substrate includes a substrate and a texture layer arranged on the substrate, a surface of the texture layer and away from the substrate is arranged with a plurality of grating grids; at least more than one of the grating grids include a plurality of grating units annularly arranged around a central point, the grating unit includes a plurality of strip-shaped protrusions, and the plurality of strip-shaped protrusions is sequentially arranged in a radial direction of a circle with the central point as the center;
in the grating grid, the strip-shaped protrusion includes a first surface close to the central point, a second surface away from the central point, and a third surface connected the first surface and the second surface, the third surface is in contact with the substrate, and an angle formed by the first surface and the third surface is less than or equal to an angle formed by the second surface and the third surface.

In the texture layer of the present disclosure, the strip-shaped protrusions with a specific structure and arrangement in the grating unit can make the reflected light on the surface of the protrusions deviate towards the central point of the grating grid. The plurality of grating units arranged annularly ensures that the reflection paths of light in different grating units can be concentrated at the central point of the grating grid. By converging the reflected light at the central point of the grating grid, a protruding effect with a bright middle area and a dark edge area of the grating grid can be achieved. On a macroscopic level, the decorative substrate presents a three-dimensional woven grid pattern, which greatly improves the decorative effect.

In an example, in the grating grid, the adjacent grating units have a common edge, and the plurality of grating units intersects at the central point.

In an example, in the grating grid, an interval is formed between the adjacent grating units, and a distance from the grating unit to the central point is less than or equal to 100 µm.

In an example, in the grating grid, an interval is formed between adjacent grating units, and a distance from the grating unit to the central point is less than or equal to 1/5 of a diameter of a circum-circle of the grating grid.

In an example, in the texture layer, the adjacent grating grids are mirror-symmetrical along an axis of symmetry; a distance from the grating grid to the axis of symmetry is less than or equal to 1/10 of a diameter of a circum-circle of the grating grid, or the distance from the grating grid to the axis of symmetry is less than or equal to 50 µm.

In an example, the angle formed by the first surface and the third surface is 11° - 40°.

In an example, the angle formed by the second surface and the third surface is 80° - 100°.

In an example, in the grating grid, the adjacent grating units are mirror-symmetric along an axis of symmetry, and an angle formed between an extension direction of each of the plurality of strip-shaped protrusion and the axis of symmetry is 20° - 70°.

In an example, a ratio of a height of the strip-shaped protrusion in a first direction to a width of the strip-shaped protrusion in a second direction is 0.05 - 0.4, wherein the first direction is perpendicular to a plane where the substrate is located, and the second direction is perpendicular to an extension direction of the strip-shaped protrusion and the first direction.

In an example, in the grating unit, in a direction away from the central point and with the central point as the center, aspect ratios of the plurality of strip-shaped protrusions gradually decrease. The aspect ratio is a ratio of a height of the strip-shaped protrusion in a first direction to a width of the strip-shaped protrusion in a second direction, wherein the first direction is perpendicular to a plane where the substrate is located, and the second direction is perpendicular to an extension direction of the strip-shaped protrusion and the first direction.

In an example, in the grating unit, a difference in aspect ratios of the adjacent strip-shaped protrusions is less than or equal to 0.1. The aspect ratio is a ratio of a height of the strip-shaped protrusion in a first direction to a width of the strip-shaped protrusion in a second direction, wherein the first direction is perpendicular to a plane where the substrate is located, and the second direction is perpendicular to an extension direction of the strip-shaped protrusion and the first direction.

In an example, a height of the strip-shaped protrusion in a first direction is 0.1µm-20µm, and the first direction is perpendicular to a plane where the substrate is located.

In an example, a width of the strip-shaped protrusion in a second direction is 1µm-150µm, and the first direction is perpendicular to a plane where the substrate is located, and the second direction is perpendicular to an extension direction of the strip-shaped protrusion and the first direction.

In an example, a length of the strip-shaped protrusion with the largest extension length in the grating unit in an extension direction of the strip-shaped protrusion is 100µm-3000µm.

In an example, a cross-sectional shape of the strip-shaped protrusion in a first direction includes one or more of a straight segment and an arc segment; the first direction is perpendicular to both the substrate and an extension direction of the strip-shaped protrusion.

In an example, a shape of the strip-shaped protrusion in its extension direction includes one or more of a saddle-shape, a zigzag-shape, and an arc-shape.

In an example, the decorative substrate further includes a modification layer, which includes one or more of a color-developing layer, a frosted layer, and a glitter layer, and the modification layer is arranged on a surface of the texture layer and/or a surface of the substrate.

The second aspect of the present disclosure provides a method for preparing a decorative substrate, includes the following steps:
a texture layer is formed on a substrate to obtain the decorative substrate, wherein preparation method of the texture layer includes one or more of transferring, etching, and thermoforming; a surface of the texture layer and away from the substrate is arranged with a plurality of grating grids; at least more than one of the grating grids include a plurality of grating units annularly arranged around a central point, and the grating units include a plurality of strip-shaped protrusions, the plurality of strip-shaped protrusions is sequentially arranged in the radial direction of a circle with the central point as the center;
in the grating grids, the strip-shaped protrusions include a first surface close to the central point, a second surface away from the central point, and a third surface connected to the first surface and the second surface, and an angle formed between the first surface and the third surface is less than or equal to an angle formed by the second surface and the third surface.

The preparation method provided by the present disclosure is simple and easy to operate, with mature technology, facilitating industrial production.

The third aspect of the present disclosure provides a cover plate, which includes the decorative substrate as described in the first aspect and a base, the decorative substrate being arranged on the surface of the base.

The fourth aspect of the present disclosure provides an electronic device, which includes the cover plate as described in the third aspect.

### Brief description of the drawings

- FIG.1 illustrates the structure of a decorative substrate in one example of the present disclosure;
- FIG.2 illustrates the structure of a texture layer in one example of the present disclosure;
- FIG.3 illustrates the structure of a texture layer in one example of the present disclosure;
- FIG.4 illustrates the structure of a grating grid in one example of the present disclosure;
- FIG.5 illustrates the structure of a grating grid in one example of the present disclosure;
- FIG.6 illustrates the structure of a grating grid in one example of the present disclosure;
- FIG.7 illustrates the structure of a grating grid in one example of the present disclosure;
- FIG.8 illustrates the structure of a grating grid in one example of the present disclosure;
- FIG.9A illustrates the arrangement of strip-shaped protrusions in a grating grid in one example of the present disclosure;
- FIG.9B illustrates a cross-sectional view of the strip-shaped protrusions in the grating grid shown in FIG.9A;
- FIG.10 illustrates the principle of a grating grid in one example of the present disclosure;
- FIG.11 illustrates different cross-sections of strip-shaped protrusions in one example of the present disclosure;
- FIG.12 illustrates the structure of a strip-shaped protrusion in one example of the present disclosure;
- FIG.13A illustrates a top view of a strip-shaped protrusion in one example of the present disclosure;
- FIG.13B illustrates the light reflection principle of a cross-section of the strip-shaped protrusion at A-A in FIG.13A;
- FIG.14 illustrates the structure of a grating grid in one example of the present disclosure;
- FIG.15 illustrates the structure of a grating grid in one example of the present disclosure;
- FIG.16 illustrates the structure of a grating grid in one example of the present disclosure;
- FIG.17 illustrates the structure of a grating grid in one example of the present disclosure;
- FIG.18A illustrates the structure of a decorative substrate in another example of the present disclosure;
- FIG.18B illustrates the structure of a cover plate in another example of the present disclosure;
- FIG.18C illustrates the structure of an electronic device in one example of the present disclosure;
- FIG.19 illustrates a top view of the decorative substrate in Example 1 of the present disclosure;
- FIG.20 illustrates the grid pattern effect of the decorative substrate in Example 1 of the present disclosure;
- FIG.21 illustrates the weaving effect of the decorative substrate in Example 1 of the present disclosure;
- FIG.22 illustrates a top view of the decorative substrate in Example 2 of the present disclosure;
- FIG.23 illustrates the grid pattern effect of the decorative substrate in Example 2 of the present disclosure;
- FIG.24 illustrates the weaving effect of the decorative substrate in Example 2 of the present disclosure;
- FIG.25 illustrates a top view of the decorative substrate in Example 3 of the present disclosure;
- FIG.26 illustrates the grid pattern effect of the decorative substrate in Example 3 of the present disclosure;
- FIG.27 illustrates the weaving effect of the decorative substrate in Example 3 of the present disclosure;
- FIG.28 illustrates a top view of the decorative substrate in Example 4 of the present disclosure;
- FIG.29 illustrates the grid pattern effect of the decorative substrate in Example 4 of the present disclosure;
- FIG.30 illustrates the weaving effect of the decorative substrate in Example 4 of the present disclosure.

### Detailed description of the invention

The technical solutions in the examples of the present disclosure will be clearly and completely described below in combination with the drawings in the examples of the present disclosure. Obviously, the described examples are merely a part of the examples of the present disclosure, not all of them. Based on the examples in the present disclosure, all other examples obtained by those of ordinary skill in the art without making creative efforts are within the scope of protection of the present disclosure.

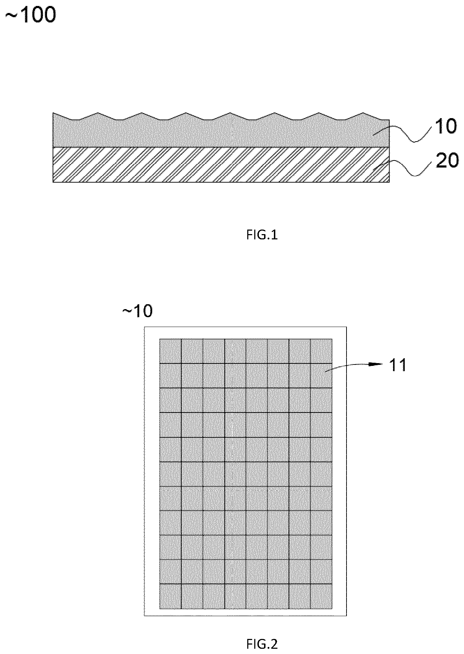

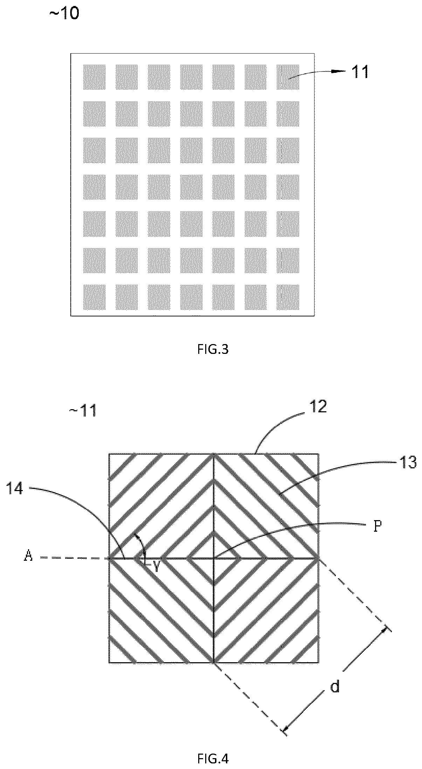

Refer to FIG.1, which illustrates the structure of a decorative substrate 100 in one example of the present disclosure. The decorative substrate 100 includes a substrate 20 and a texture layer 10 arranged on the substrate 20. The substrate 20 includes but is not limited to one or more of plastic, metal, ceramic, and glass. In the implementation methods of the present disclosure, a surface of the texture layer 10 is arranged with a plurality of grating grids, which can be arranged continuously or intermittently. Refer to FIG.2, which illustrates the structure of the texture layer 10 in one example of the present disclosure, showing a plurality of grating grids 11 arranged continuously on the surface of the texture layer 10. Refer to FIG.3, which illustrates the structure of the texture layer 10 in one example of the present disclosure, showing a plurality of grating grids 11 arranged intermittently on the surface of the texture layer 10. In some implementation methods of the present disclosure, a plurality of grating grids is arranged intermittently, with adjacent grating grids being mirror-symmetric along a symmetry axis. A distance from the grating grid to the symmetry axis is less than or equal to 1/10 of the diameter of the circum-circle of the grating grid, the distance from the grating grid to the axis of symmetry is less than or equal to 50 µm. The distance from the grating grid to the symmetry axis refers to the distance from the point in the grating grid closest to the symmetry axis to the symmetry axis.

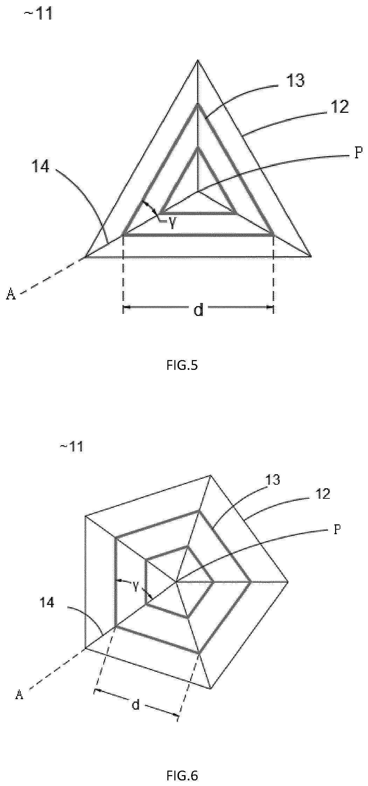

In some examples of the present disclosure, the grating grid includes a plurality of grating units annularly arranged around a central point. The grating unit includes the plurality of strip-shaped protrusions sequentially arranged in a radial direction of a circle centered on the central point. It should be noted that the circular arrangement of the grating unit refers to the overall shape arrangement of the grating unit, and it does not limit the arrangement of the strip-shaped protrusions inside the grating unit. Moreover, extension directions of the plurality of strip-shaped protrusions can be parallel or not parallel to each other. In some examples of the present disclosure, the grating grid includes a plurality of grating units annularly arranged around the central point and joined together, that is, the adjacent grating units have a common edge, and a plurality of grating units intersects at the central point. Refer to FIG.4, which illustrates the structure of a grating grid 11 in one example of the present disclosure. The grating grid 11 is quadrilateral in shape and includes four grating units 12 annularly arranged around the central point P and joined together. The grating unit 12 is quadrilateral in shape and includes several strip-shaped protrusions 13 with mutually parallel extension directions. Refer to FIG.5, which illustrates the structure of a grating grid 11 in one example of the present disclosure. The grating grid 11 is triangular in shape and includes three grating units 12 arranged in a circular pattern around the central point P and joined together. The grating unit 12 is triangular in shape and includes several strip-shaped protrusions 13 with mutually parallel extension directions. Refer to FIG.6, which illustrates the structure of a grating grid 11 in one example of the present disclosure. The grating grid 11 is pentagonal in shape and includes five grating units 12 annularly arranged around the central point P and joined together. The grating unit 12 is triangular in shape and includes several strip-shaped protrusions 13 with mutually parallel extension directions.

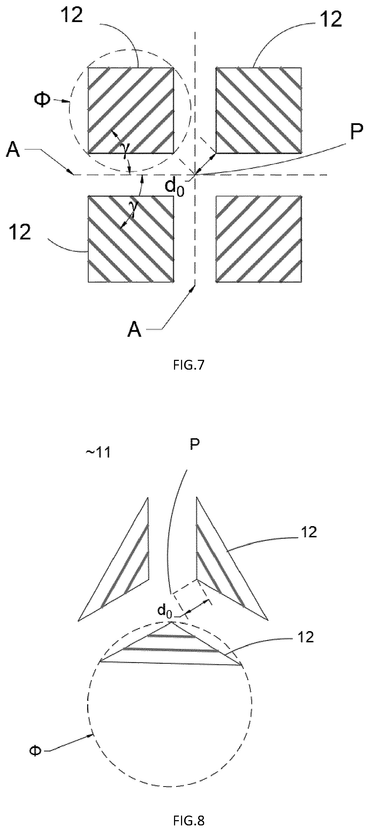

In some examples of the present disclosure, an interval is formed between the adjacent grating units in the grating grid. Please refer to FIG.7, which illustrates the structure of a grating grid 11 in one example of the present disclosure. In FIG.7, the adjacent grating units 12 in the grating grid 11 are arranged with intervals, and a distance d₀ from the grating unit 12 to the central point P is the distance from the point on the grating unit 12 closest to the central point P to the central point P. Refer to FIG.8, which illustrates the structure of a grating grid 11 in one example of the present disclosure. In FIG. 8, the adjacent grating units 12 in the grating grid 11 are arranged with intervals, and the shape of the grating unit 12 is triangular. In some examples of the present disclosure, the distance d₀ from the grating unit 12 to the central point P is less than or equal to 100µm. In some examples of the present disclosure, the distance d₀ from the grating unit 12 to the central point P is less than or equal to 1/5 of a diameter Φ of a circum-circle of the grating grid 11. Controlling the interval distance between grating grids 11 can ensure that the texture layer has a more pronounced woven grid pattern effect overall.

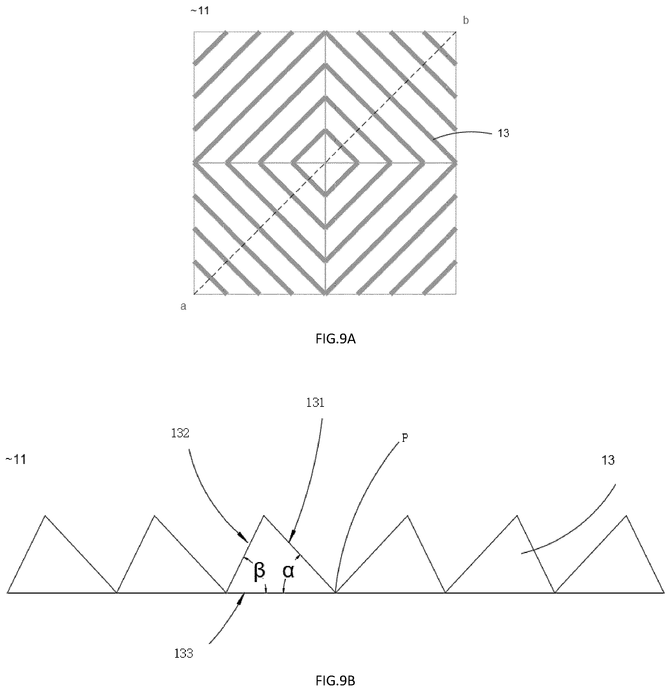

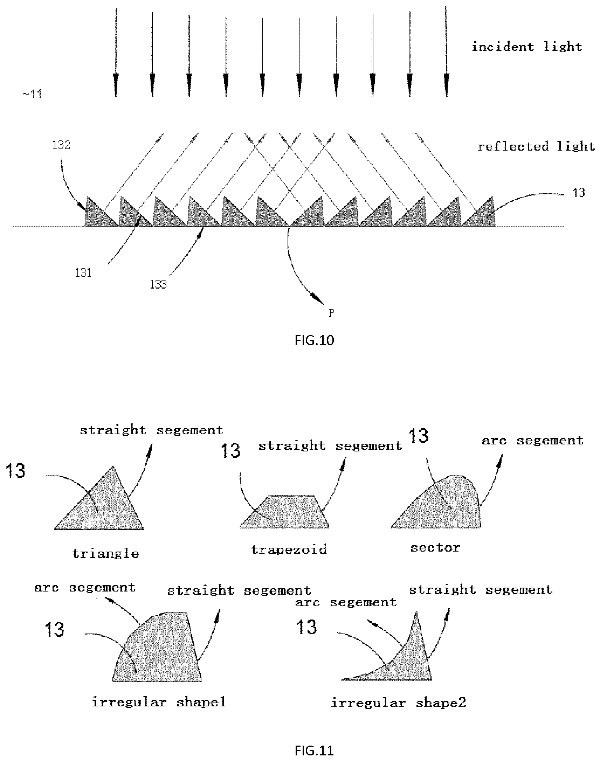

In some examples of the present disclosure, the strip-shaped protrusion includes a first surface close to the central point, a second surface away from the central point, and a third surface connected to the first and second surfaces. An angle between the first surface and the third surface is less than or equal to an angle between the second surface and the third surface of the strip-shaped protrusion. Here, the third surface of the strip-shaped protrusion refers to the surface of the strip-shaped protrusion closest to the substrate and is parallel to the plane of the substrate. For example, in this example, the third surface of the strip-shaped protrusion is the surface in contact with the substrate. Refer to FIG.9A and 9B together. FIG.9A illustrates the arrangement direction of the strip-shaped protrusions 13 in the grating grid 11 of the present disclosure example, and FIG.9B illustrates a cross-sectional view of the strip-shaped protrusions 13 in the grating grid 11 shown in FIG.9A. Specifically, in FIG.9A, a plurality of strip-shaped protrusions 13 is sectioned along the plane where line ab is located, resulting in the cross-sectional view of a plurality of strip-shaped protrusions 13 shown in FIG.9B. The strip-shaped protrusion 13 has a first surface 131 close to the central point P, a second surface 132 away from the central point P, and a third surface 133 connected to the first surface 131 and the second surface 132, with the third surface 133 in contact with the substrate (20). The angle between the first surface 131 and the third surface 133 is α, and the angle between the second surface 132 and the third surface 133 is β, with α≤β. The condition α≤β ensures that the light reflected from the surface of the strip-shaped protrusion 13 can be focused at the central point P of the grating grid 11. Refer to FIG. 10, which illustrates the principle of the grating grid 11 in one example of the present disclosure. When incident light shines on the surface of the strip-shaped protrusion 13, due to the strip-shaped protrusion 13 being arranged around the central point P and the angle α between the first surface 131 close to the central point P and the third surface 133 being less than or equal to the angle β between the second surface 132 and the third surface 133, the reflection path of the incident light can be deflected towards the central point P of the grating grid 11. The reflected light from a plurality of strip-shaped protrusions 13 converges at the central point P of the grating grid 11, making the brightness at the central point P significantly higher than that at the outer side, and the brightness gradually decreases along the radial direction of the circle centered on the central point P, thus creating a raised grid effect.

In some examples of the present disclosure, an angle α between the first surface 131 and the third surface 133 of the strip-shaped protrusion 13 is 11° to 40°, that is, 11°≤α≤40°. The angle α can specifically be but is not limited to 11°, 15°, 18°, 20°, 25°, 30°, 35°, or 40°. In some examples of the present disclosure, an angle β between the second surface 132 and the third surface 133 is 80° to 100°, that is, 80°≤β≤100°. The angle β can specifically be but is not limited to 80°, 85°, 90°, 95°, or 100°. Controlling the angle α between the first surface 131 and the third surface 133 and the angle β between the second surface 132 and the third surface 133 is conducive to focusing the light reflected by the strip-shaped protrusion 13 at the central point P of the grating grid 11, thereby enhancing the three-dimensional effect of the woven grid pattern.

In present disclosure, a first direction, a second direction, and an extension direction of the strip-shaped protrusion are mutually perpendicular. The second direction and the extension direction of the strip-shaped protrusion are parallel to the substrate, and the first direction is perpendicular to the plane of the substrate. In some examples of the present disclosure, the cross-sectional shape of the strip-shaped protrusion perpendicular to its extension direction includes one or more of a straight segment and an arc segment. The arc segment includes an upward convex arc segment and a downward convex arc segment. This cross-sectional shape can be understood as the intersection line obtained by cutting the strip-shaped protrusion with a plane perpendicular to the extension direction of the strip-shaped protrusion and perpendicular to the substrate, that is, the intersection line of the outer surface of the strip-shaped protrusion and the plane is the trace of the cut. Refer to FIG.11, which illustrates the cross-sectional views of different strip-shaped protrusions 13 in one example of the present disclosure. The cross-section of the strip-shaped protrusion 13 includes triangular, trapezoidal, fan-shaped, or irregular shaped. A trace of the strip-shaped protrusion 13 with a triangular or trapezoidal cross-section is a straight segment, and the trace of the strip-shaped protrusion 13 with a fan-shaped cross-section is an arc segment. The trace of the strip-shaped protrusion 13 with an irregular shape 1 includes straight segments and upward convex arc segments, and the trace of the strip-shaped protrusion 13 with an irregular shape 2 includes straight segments and downward convex arc segments. In some examples of the present disclosure, the vertex connection line of the strip-shaped protrusion 13 at different cut traces is used as the dividing line between the first surface and the second surface. The vertex of the strip-shaped protrusion 13 refers to the highest point of the strip-shaped protrusion 13 relative to the third surface 133 in the first direction. In some example of the present disclosure, the first surface of the strip-shaped protrusion 13 is an upward convex arc surface, as shown in the cross-sectional view of the irregular shape 1 in FIG.11, that is, the cut trace of the cross-section of the strip-shaped protrusion 13 close to the central point is an upward convex arc segment. The reflected light of this structure of the strip-shaped protrusion 13 is more divergent than that of the planar structure of the strip-shaped protrusion 13, and the weaving effect presented is softer. In some examples of the present disclosure, the first surface of the strip-shaped protrusion 13 is a downward convex arc surface, as shown in the cross-sectional view of the irregular shape 2 in FIG.11, that is, the cut trace of the cross-section of the strip-shaped protrusion 13 close to the central point is a downward convex arc segment. The reflected light of this structure of the strip-shaped protrusion 13 is more concentrated than that of the planar structure of the strip-shaped protrusion 13, the brightness at the center of the grating grid is higher, and the weaving effect presented is sharper and clearer, with a better three-dimensional effect.

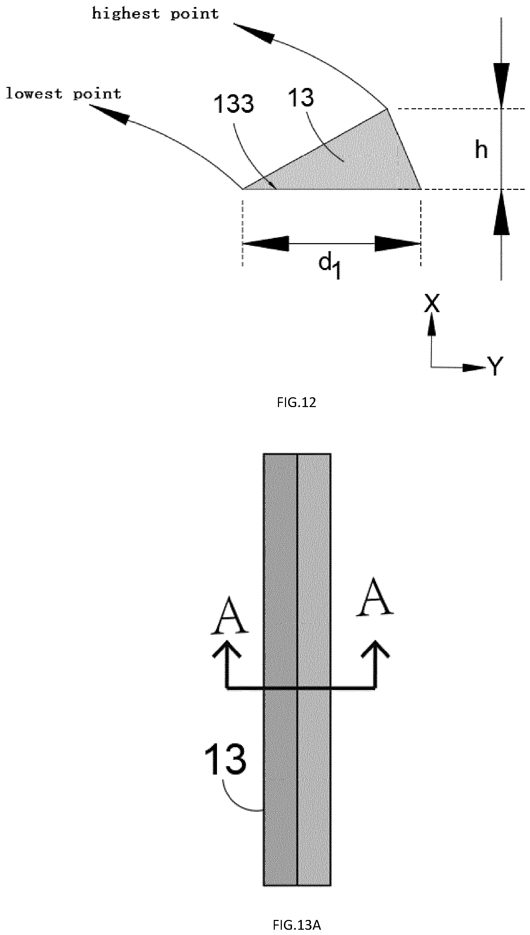

In the present disclosure, a height of the strip-shaped protrusion 13 refers to the height difference between the highest point of the strip-shaped protrusion 13 relative to the third surface 133 and the third surface 133. A width of the strip-shaped protrusion 13 refers to the maximum width of the strip-shaped protrusion 13 in the second direction. Refer to FIG.12, which illustrates the structure of the strip-shaped protrusion 13 in one example of the present disclosure. The length of the bottom edge of the cross-section of the strip-shaped protrusion 13 perpendicular to the extension direction of the strip-shaped protrusion 13 is the width d₁ of the strip-shaped protrusion 13. The distance from the highest point of the cross-section of the strip-shaped protrusion 13 perpendicular to the extension direction of the strip-shaped protrusion 13 to the third surface 133 of the strip-shaped protrusion 13 is the height h of the strip-shaped protrusion 13, which can also be calculated by the height difference between the highest and lowest points of the cut trace. In some examples of the present disclosure, the height h of the strip-shaped protrusion 13 in the first direction X is 0.1µm to 20µm. The height h can specifically be but is not limited to 0.1µm, 0.5µm, 1µm, 3µm, 5µm, 10µm, 15µm, or 20µm. In some examples of the present disclosure, the height h of the strip-shaped protrusion 13 in the first direction X is 1µm to 20µm. In some examples of the application, the width d₁ of the strip-shaped protrusion 13 in the second direction is 1µm to 150µm. The width d₁ can specifically be but is not limited to 1µm, 5µm, 10µm, 30µm, 50µm, 65µm, 80µm, 100µm, 120µm, or 150µm. In some examples, the width d₁ of the strip-shaped protrusion 13 in the second direction is less than or equal to 5 µm. A smaller width of the strip-shaped protrusion 13 can promote light scattering, thereby presenting a colorful effect of the grating grid. In some examples, the width d₁ of the strip-shaped protrusion 13 in the second direction Y is 30µm to 100µm. The reflection effect of this width of the strip-shaped protrusion 13 on light is more obvious, which is more conducive to enhancing the three-dimensional effect of the woven grid pattern. Here, the first direction X is perpendicular to the plane of the substrate 20, and the second direction Y is perpendicular to the extension direction of the strip-shaped protrusion 13 and the first direction X.

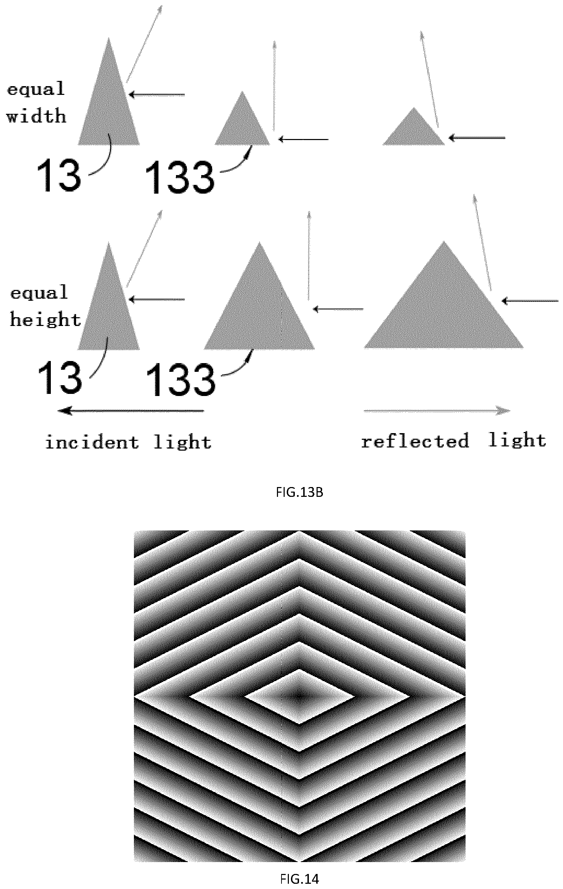

In some examples of the present disclosure, a ratio of the height h of the strip - shaped protrusion 13 in the first direction X to the width d1 of the strip - shaped protrusion 13 in the second direction Y (i.e., the width d1 of the third surface 133 in the second direction Y) is 0.05 - 0.4. Specifically, the ratio of the height h of the strip - shaped protrusion 13 to the width d1 of the third surface 133 of the strip - shaped protrusion 13 can specifically be but is not limited to 0.05, 0.1, 0.2, 0.3 or 0.4. The aspect ratio of the strip - shaped protrusion 13 affects the angle of the reflected light, and thus affects the intensity of the light and shadow effect. Refer to FIG. 13A and FIG.13B together. FIG. 13A is a top view of the strip - shaped protrusion 13 provided by an example of the present disclosure, and FIG.13B is a schematic drawing of the principle of light reflection associated with the cross - section of the strip - shaped protrusion 13 at A - A. In FIG. 13B, the color of the incident light path is darker, and the color of the reflected light path is lighter. Under the same incident light conditions, the aspect ratio of the cross - section affects the amount of light reflected into the human eye. When the width of the third surface 133 of the strip - shaped protrusion 13 is the same, the smaller the height of the strip - shaped protrusion 13, the less light is reflected into the human eye. When the height of the strip - shaped protrusion 13 is the same, the larger the width of the third surface 133 of the strip - shaped protrusion 13, the less light is reflected into the human eye. Generally, the larger the ratio of the height of the strip - shaped protrusion 13 to the width of the third surface 133 of the strip - shaped protrusion 13, the more light is reflected into the human eye, the brighter the light and shadow effect is, and the more prominent the presented weaving effect is.

In some examples of the present disclosure, in the grating unit, in a direction away from the central point and with the central point as the center, aspect ratios of the plurality of strip - shaped protrusions gradually decrease. The larger the aspect ratio of the strip-shaped protrusion, the brighter the reflected light is. The above-mentioned gradual change of the aspect ratio can further enhance the contrast between the center and the edge of the grating grid, thereby strengthening the three-dimensional sense of the grating grid. The aspect ratio of the strip-shaped protrusion is the ratio of the height of the strip-shaped protrusion in the first direction to the width of the strip-shaped protrusion in the second direction. The first direction is perpendicular to a plane where the substrate is located, and the second direction is perpendicular to an extension direction of the strip-shaped protrusion and the first direction. In some examples of the present disclosure, in the grating unit, the difference in aspect ratios of the adjacent strip-shaped protrusions is less than or equal to 0.1. Controlling the difference in aspect ratios of the adjacent strip-shaped protrusions can make the gradual change in brightness more natural and the effect of the woven grid pattern more vivid.

In some examples of the present disclosure, a size of the grating grid is 100µm - 3000µm. The size of the grating grid refers to the length of the strip-shaped protrusion with the largest extension length in the grating unit in an extension direction of the strip-shaped protrusion. Specifically, the length of the strip-shaped protrusion with the largest extension length in the grating unit in its extension direction can be, but is not limited to, 100µm, 200µm, 400µm, 600µm, 800µm, 1000µm, 1500µm, 2000µm, 2500µm or 3000µm.

Refer to FIG.4 again. Lengths of the plurality of strip-shaped protrusions 13 in the same grating unit 12 in an extension direction of the strip - shaped protrusion 13 first gradually increase and then gradually decrease in the direction away from the central point P. Refer to FIG. 5 and FIG. 6 again. Lengths of the plurality of strip-shaped protrusions 13 in the same grating unit 12 in the extension direction of the strip-shaped protrusion 13 gradually increase in the direction away from the central point P.

Refer to FIG. 4 - FIG. 6. In FIG. 4 - FIG. 6, a length of the strip-shaped protrusion 13 with the largest extension length in the grating unit 12 in an extension direction of the strip-shaped protrusion 13 is d. In some examples, when the size of the grating grid 11 is less than or equal to 150µm, the woven grid pattern effect presented by the decorative substrate is indistinct. In some examples, when the size of the grating grid 11 is greater than 150µm, the woven grid pattern effect presented by the decorative substrate is relatively clear. In some examples of the present disclosure, the length of the strip-shaped protrusion 13 with the largest extension length in the grating unit 12 in its extension direction is 200µm - 500µm. The woven grid pattern presented by the grating grid of this size has a relatively obvious three-dimensional effect and a relatively delicate texture.

In some examples of the present disclosure, in the grating grid, the adjacent grating units are mirror-symmetric along the axis of symmetry, and an angle between an extension direction of each of the plurality of strip-shaped protrusion and the axis of symmetry is 20° - 70°. Refer to FIG. 7. The extension direction of the strip-shaped protrusion 13 forms an angle γ with the axis of symmetry A, and the opening direction of the angle γ faces the central point P side of the grating grid 11. In some examples of the present disclosure, the adjacent grating units 12 have a common edge 14 in the grating grid 11. The position schematic drawing of the common edge can be referred to FIG. 4 - FIG.6. Among them, the extension direction of the strip-shaped protrusion 13 forms an angle γ with the common edge 14 or the axis of symmetry A. Specifically, the angle γ formed by the extension direction of the strip-shaped protrusion 13 and the common edge 14 or the axis of symmetry A can be, but is not limited to, 20°, 30°, 50°, 60° or 70°. The extension direction of the strip-shaped protrusion 13 also affects the angle of the reflected light, and thus affects the intensity of the light and shadow effect. When the angle γ formed by the extension direction of the strip-shaped protrusion 13 and the axis of symmetry A is controlled to be 20° - 70°, the light reflected by the strip-shaped protrusions 13 in different grating units can be more concentrated, thereby increasing the brightness at the central point P of the grating grid 11. In some examples of the present disclosure, the angle γ formed by the extension direction of the strip - shaped protrusion 13 and the axis of symmetry A is 30° - 60°. Within this angle range, the light and shadow contrast of the grating grid is high, and the three-dimensional effect of the woven grid pattern is stronger.

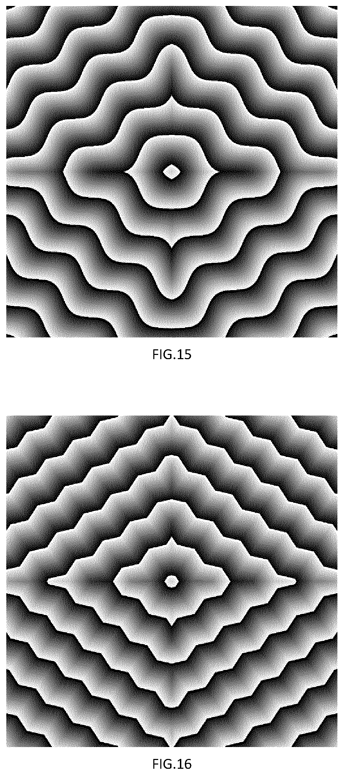

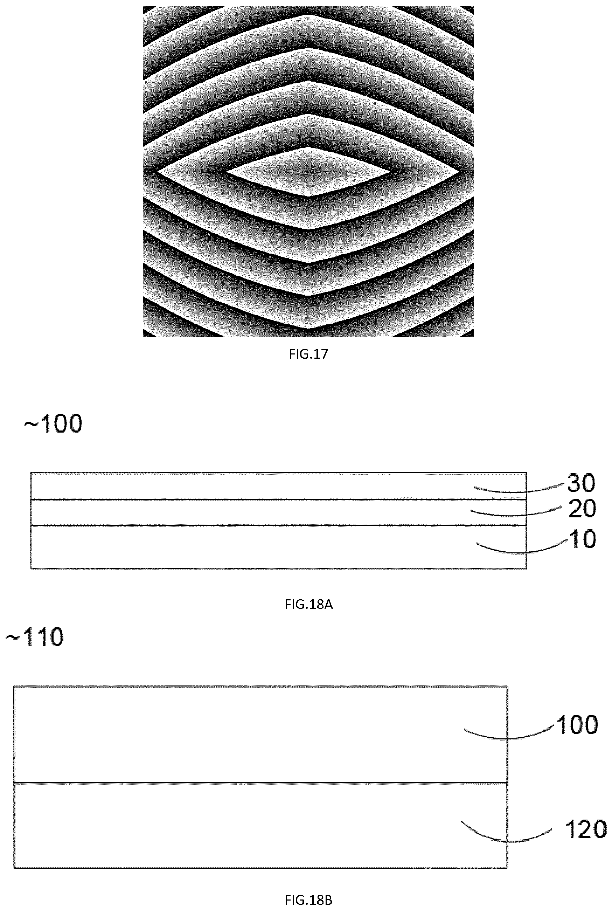

In some examples of the present disclosure, a shape of the strip-shaped protrusion in its extension direction includes one or more of a linear-shape, a saddle-shape, a zigzag-shape, and an arc-shape. The shape of the strip-shaped protrusion in its extension direction can be understood as the connecting line of the projections of the vertices of the strip-shaped protrusion at different positions in its extension direction on the substrate. Refer to FIG.14, which illustrates the structure of a grating grid in one example of the present disclosure. The grating grid contains four grating units, and the shape of the strip-shaped protrusion in the grating unit in its extension direction is linear-shape. Refer to FIG.15, which is a schematic structural drawing of a grating grid provided by an example of the present disclosure. The grating grid contains four grating units, and the shape of the strip-shaped protrusion in the grating unit in its extension direction is saddle-shape. Refer to FIG.16, which is a schematic structural drawing of a grating grid provided by an example of the present disclosure. The grating grid contains four grating units, and the shape of the strip-shaped protrusion in the grating unit in its extension direction is zigzag-shape. The strip-shaped protrusions that are saddle-shape and zigzag-shape in their extension direction can further add a matte finish to the decorative layer based on the woven grid pattern effect, thus enriching the appearance of the decorative substrate. Refer to FIG. 17, which is a schematic structural drawing of a grating unit provided by an example of the present disclosure. The grating grid contains four grating units, and the strip-shaped protrusions in its grating units are arc-shape in their extension direction. The arc-shaped strip-shaped protrusions can adjust the details of the grating grid protrusions, making the appearance of the decorative substrate more diverse.

In some examples of the present disclosure, refer to FIG. 18A, which is a schematic structural drawing of a decorative substrate 100 provided by another example of the present disclosure. The decorative substrate 100 further includes a modification layer 30, and the modification layer 30 includes one or more of color-developing layer, a frosted layer, and a glitter layer. In the examples of the present disclosure, the color-developing layer can be a coating layer or an ink layer, as long as it has a certain color. The combination of the color-developing layer and the texture layer can achieve color changes in a single-color coating, enabling the decorative substrate to have a rich color appearance. The frosted layer has a certain anti-slip function and a softer visual effect, which can enrich the appearance of the product. The glitter layer refers to the modification layer 30 that can present a sparkling effect. In some examples, the glitter layer includes a coating doped with glitter particles. Setting the glitter layer can make the decorative substrate have a certain dazzling effect. In this example, the modification layer 30 is arranged on the surface of the texture layer 10 facing away from the substrate 20. In some examples, the modification layer is arranged on the surface of the substrate. In some examples, the modification layer is arranged on the surfaces of the substrate and the texture layer.

In the decorative substrate provided by the present disclosure, the texture layer has a regularly-distributed micro-texture structure. When light shines on the texture surface, the strip-shaped protrusions in the texture layer with different angles, widths, and cross-sections cause light of different wavelengths to form a real visual sense with characteristic changes in highlights, mid- tones, and shadows through reflection, scattering, or refraction, making the surface of the decorative substrate present a three-dimensional light and shadow effect of raised small grids, thus greatly enhancing the aesthetics of the product.

The present disclosure also provides a method for preparing the decorative substrate. In the examples of the present disclosure, the preparation method of the texture layer includes one or more of etching, UV transferring, and hot-pressing molding. In some examples, the substrate includes a transparent film. For example, the substrate can be a polyester substrate (PET film), a polycarbonate substrate (PC film), a polymethyl methacrylate substrate (PMMA film), or a PC/PMMA composite sheet. The preparation method of the decorative substrate includes: a texture master is made with a texture pattern on a mold according to the pattern of the texture layer, and the texture master is transferred onto the surface of the substrate to obtain the decorative substrate. In some examples, the substrate includes a plastic sheet. The preparation method of the decorative substrate includes: the texture master is transferred onto the surface of the substrate and obtained the decorative substrate through hot-pressing molding. The obtained decorative substrate is a textured plastic sheet. In some examples, the substrate includes glass. The preparation method of the decorative substrate includes: a mask is prepared on the surface of the substrate according to the pattern of the texture layer, the substrate is etched. The etching effect is stronger at the thinner parts of the mask and weaker at the thicker parts of the mask, thereby forming a texture pattern on the surface of the substrate to obtain the decorative substrate. The obtained decorative substrate is textured glass. The preparation method of the decorative substrate provided by the present disclosure has a mature technology, a simple process, and high product stability, which can improve the yield rate of products and is suitable for mass production.

Refer to FIG. 18B, which is a schematic structural drawing of a cover plate 110 provided by an example of the present disclosure. The present disclosure also provides a cover plate 110. The cover plate 110 includes the decorative substrate 100 of the present disclosure and a base 120. The base is used to enhance the structural strength of the cover plate. The base can be one or more of plastic, metal, ceramic, and glass. This cover plate can present a three-dimensional woven grid pattern effect similar to fabric, thus greatly improving the aesthetics and having a good market prospect. In some examples of the present disclosure, the cover plate 110 can be used for the housing of communication devices. The unique appearance of this cover plate can improve the product's recognizability.

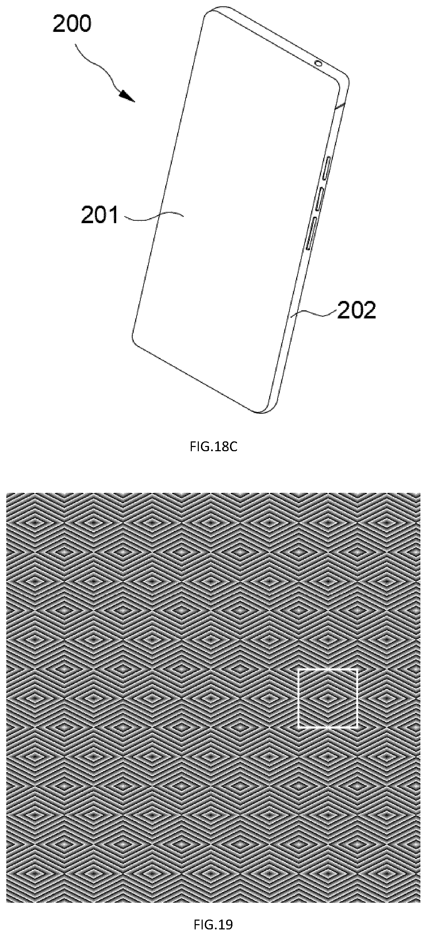

The present disclosure also provides an electronic device, and this electronic device includes the above-mentioned cover plate. Refer to FIG. 18C, which is a schematic structural drawing of an electronic device 200 provided by an example of the present disclosure. The electronic device 200 includes a display component 201 and a housing 202, and the housing 202 includes the cover plate of the present disclosure. In the examples of the present disclosure, the electronic device can specifically be a mobile phone, a computer, a watch, a USB flash drive, an electronic cigarette, a wearable device, a digital camera, etc.

The following further illustrates the examples of the present disclosure through specific examples.

### Example 1

A decorative substrate, and its preparation method includes: a grayscale image of the texture pattern is designed, the grayscale image is imported into a control computer, and the decorative substrate is obtained through processes such as laser direct writing by identifying the grayscale values on the grayscale image.

Refer to FIG. 19, which is a top-view of the decorative substrate provided by Example 1 of the present disclosure. In FIG. 19, a plurality of grating grids is arranged on the surface of the decorative substrate. The area outlined by the white frame is one grating grid. One grating grid includes four grating units arranged annularly around a central point and joint together. Each grating unit includes a plurality of strip-shaped protrusions with mutually parallel extension directions, and the plurality of strip-shaped protrusions is sequentially arranged in the radial direction of a circle with the central point as the center.

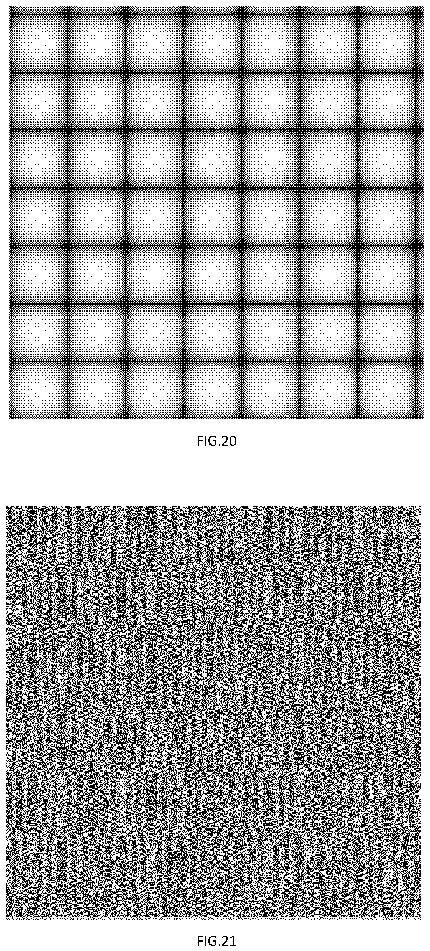

Refer to FIG. 20, which is a schematic drawing of the grid pattern effect of the decorative substrate provided by Example 1 of the present disclosure. As can be seen from FIG. 20, there is a certain brightness gradient inside the grating grid, and the arrangement of a plurality of grating grids can achieve the grid pattern effect. Refer to FIG. 21, which is a schematic drawing of the weaving effect of the decorative substrate provided by Example 1 of the present disclosure. As can be seen from FIG. 21, the decorative substrate of the present disclosure can present a three-dimensional woven grid pattern effect on a macroscopic scale.

### Example 2

A decorative substrate, and its preparation method includes: a grayscale image of the texture pattern is designed, the grayscale image is imported into a control computer, and the decorative substrate is obtained through processes such as laser direct writing by identifying the grayscale values on the grayscale image.

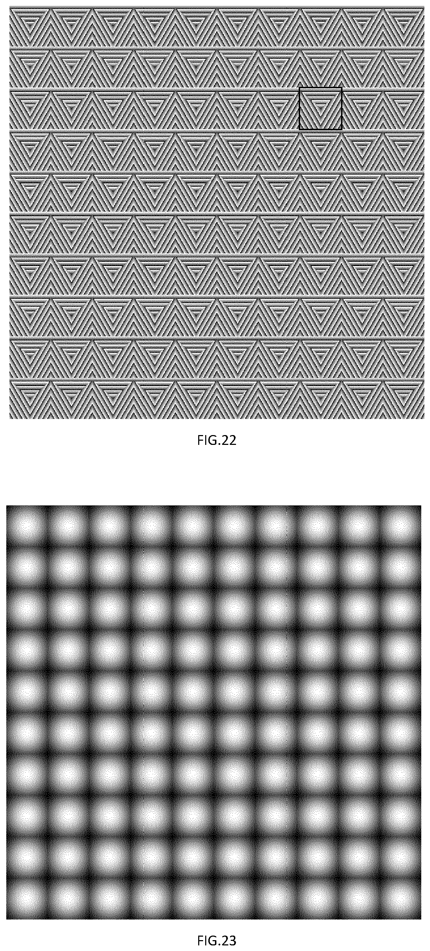

Refer to FIG. 22, which is a top-view of the decorative substrate provided by Example 2 of the present disclosure. In FIG. 22, a plurality of grating grids is arranged on the surface of the decorative substrate. The area outlined by the black frame is one grating grid. One grating grid includes three grating units arranged annularly around a central point and joint together. Each grating unit includes a plurality of strip-shaped protrusions with mutually parallel extension directions, and the plurality of strip-shaped protrusions is sequentially arranged in the radial direction of a circle with the central point as the center.

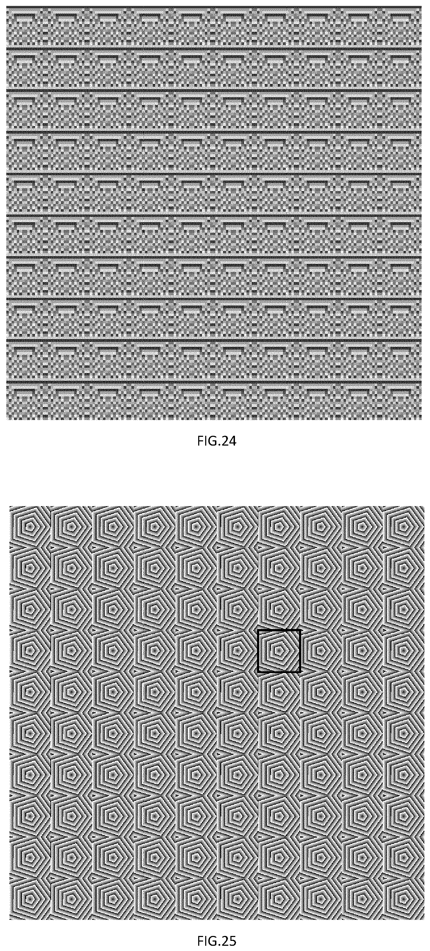

Refer to FIG. 23, which is a schematic drawing of the grid pattern effect of the decorative substrate provided by Example 2 of the present disclosure. As can be seen from FIG. 23, there is a certain brightness gradient inside the grating grid, and the arrangement of a plurality of grating grids can achieve the grid pattern effect. Refer to FIG. 24, which is a schematic drawing of the weaving effect of the decorative substrate provided by Example 2 of the present disclosure. As can be seen from FIG. 24, the decorative substrate of the present disclosure can present a three-dimensional woven grid pattern effect on a macroscopic scale.

### Example 3

A decorative substrate, and its preparation method includes: a grayscale image of the texture pattern is designed, the grayscale image is imported into a control computer, and he decorative substrate is obtained through processes such as laser direct writing by identifying the grayscale values on the grayscale image.

Refer to FIG. 25, which is a top-view of the decorative substrate provided by Example 3 of the present disclosure. In FIG. 25, a plurality of grating grids is arranged on the surface of the decorative substrate. The area outlined by the black frame is one grating grid. One grating grid includes five grating units arranged annularly around a central point and spliced together. Each grating unit includes a plurality of strip-shaped protrusions with mutually parallel extension directions, and the plurality of strip-shaped protrusions is sequentially arranged in the radial direction of a circle with the central point as the center.

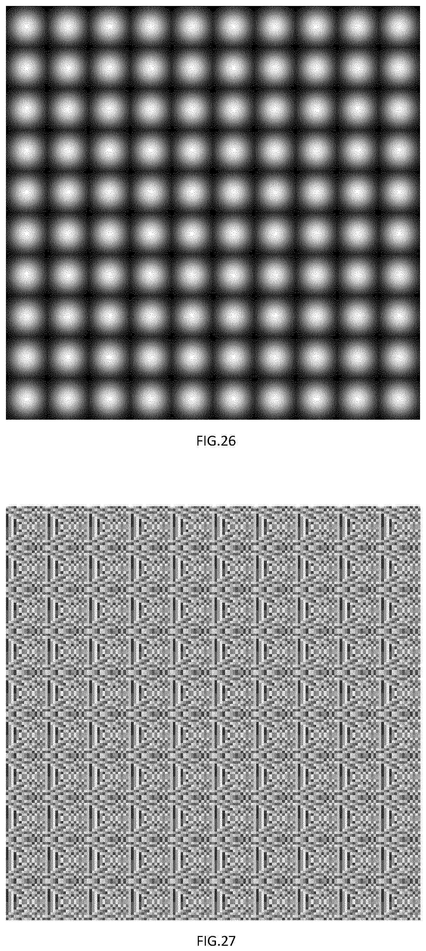

Refer to FIG. 26, which is a schematic drawing of the grid pattern effect of the decorative substrate provided by Example 3 of the present disclosure. As can be seen from FIG. 26, there is a certain brightness gradient inside the grating cell, and the arrangement of a plurality of grating grids can achieve the grid pattern effect. Please refer to FIG. 27, which is a schematic drawing of the weaving effect of the decorative substrate provided by Example 3 of the present disclosure. As can be seen from FIG. 27, the decorative substrate of the present disclosure can present a three-dimensional woven grid pattern effect on a macroscopic scale.

### Example 4

A decorative substrate, and its preparation method includes: a grayscale image of the texture pattern is designed, the grayscale image is imported into a control computer, and the decorative substrate is obtained through processes such as laser direct writing by identifying the grayscale values on the grayscale image.

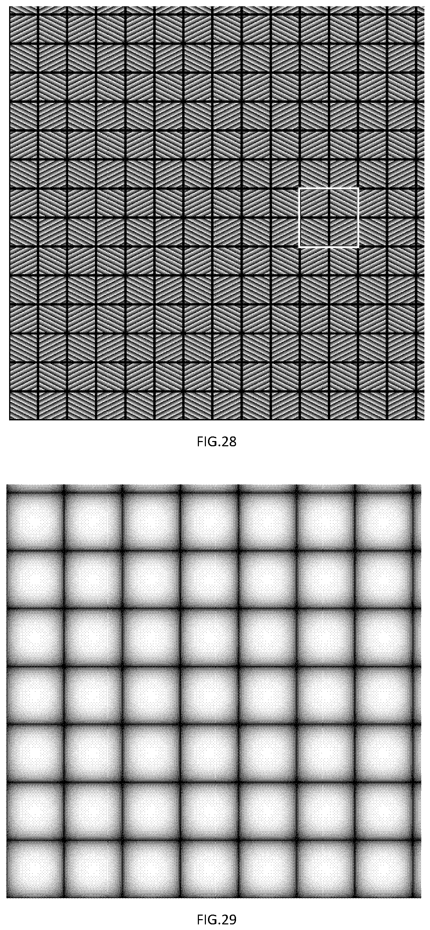

Refer to FIG. 28, which is a top-view of the decorative substrate provided by Example 4 of the present disclosure. In FIG. 28, a plurality of grating grids is arranged on the surface of the decorative substrate. The area outlined by the white frame is one grating cell. One grating grid includes four grating units arranged annularly around a central point, with intervals between the grating units. Each grating unit includes a plurality of strip-shaped protrusions with mutually parallel extension directions, and the plurality of strip-shaped protrusions is sequentially arranged in the radial direction of a circle with the central point as the center.

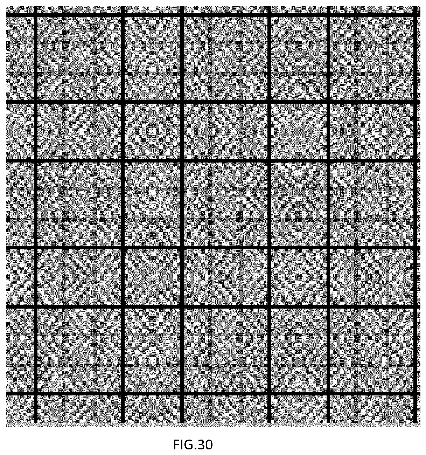

Refer to FIG. 29, which is a schematic drawing of the grid pattern effect of the decorative substrate provided by Example 4 of the present disclosure. As can be seen from FIG. 29, there is a certain brightness gradient inside the grating cell, and the arrangement of a plurality of grating grids can achieve the grid pattern effect. Refer to FIG. 30, which is a schematic drawing of the weaving effect of the decorative substrate provided by Example 4 of the present disclosure. As can be seen from FIG. 30, the decorative substrate of the present disclosure can present a three-dimensional woven grid pattern effect on a macroscopic scale.

The above-mentioned examples only represent one example of the present invention. The description is relatively specific and detailed, but it should not be construed as limiting the scope of the patent of the present invention. It should be noted that for those of ordinary skill in the art, without departing from the design concept of the present disclosure, several modifications and improvements can be made, and these all fall within the protection scope of the present invention. Therefore, the protection scope of the patent of the present invention should be subject to the appended claims.

## Claims

1. A decorative substrate (100), comprising a substrate (20) and a texture layer (10) arranged on the substrate (20), a surface of the texture layer (10) and away from the substrate (20) being arranged with a plurality of grating grids (11); at least more than one of the grating grids (11) comprising a plurality of grating units (12) annularly arranged around a central point (P); the grating unit (12) comprising a plurality of strip-shaped protrusions (13), the plurality of strip-shaped protrusions (13) being sequentially arranged in a radial direction of a circle with the central point (P) as the center;
in the grating grid(11), the strip-shaped protrusion (13) comprising a first surface (131) close to the central point (P), a second surface (132) away from the central point (P), and a third surface (133) connected to the first surface (131) and the second surface (132); the third surface (133) being in contact with the substrate (20), and an angle (α) formed by the first surface (131) and the third surface (133) being less than or equal to an angle (β) formed by the second surface (132) and the third surface (133).

2. The decorative substrate (100) according to claim 1, wherein in the grating grid (11), the adjacent grating units (12) have a common edge (14), and the plurality of grating units (12) intersects at the central point (P).

3. The decorative substrate (100) according to claim 1, wherein in the grating grid (11), an interval is formed between the adjacent grating units (12), and a distance from the grating unit (12) to the central point (P) is less than or equal to 100µm.

4. The decorative substrate (100) according to claim 1, wherein in the grating grid (11), an interval is formed between the adjacent grating units (12), and a distance (d0) from the grating unit (12) to the central point (P) is less than or equal to 1/5 of a diameter (Φ) of a circum-circle of the grating grid (11).

5. The decorative substrate (100) according to any one of claims 1to 4, wherein the angle (α) formed by the first surface (131) and the third surface (133) is 11° - 40°.

6. The decorative substrate according to any one of claims 1 to 4, wherein the angle (β) formed by the second surface (132) and the third surface (133) is 80° - 100°.

7. The decorative substrate (100) according to any one of claims 1 to 4, wherein in the grating grid (11), the adjacent grating units (12) are mirror-symmetric along an axis of symmetry (A), and an angle (γ) formed between an extension direction of each of the plurality of strip-shaped protrusion (13) and the axis of symmetry (A) is 20° - 70°.

8. The decorative substrate (100) according to any one of claims 1 to 4, wherein a ratio of a height of the strip-shaped protrusion (13) in a first direction (X) to a width of the strip-shaped protrusion (13) in a second direction (Y) is 0.05-0.4, wherein the first direction (X) is perpendicular to a plane where the substrate (20) is located, and the second direction (Y) is perpendicular to an extension direction of the strip-shaped protrusion (13) and the first direction (X).

9. The decorative substrate (100) according to any one of claims 1 to 4, wherein in the grating unit (12), in a direction away from the central point (P) and with the central point (P) as the center, aspect ratios of the plurality of strip-shaped protrusions (13) gradually decrease, the aspect ratio is a ratio of a height of the strip-shaped protrusion (13) in a first direction (X) to a width of the strip-shaped protrusion (13) in a second direction (Y), the first direction (X) is perpendicular to a plane where the substrate (20) is located, and the second direction (Y) is perpendicular to an extension direction of the strip-shaped protrusion(13) and the first direction (X).

10. The decorative substrate (100) according to any one of claims 1 to 4, wherein in the grating unit (12), a difference in aspect ratios of the adjacent strip-shaped protrusions (13) is less than or equal to 0.1, the aspect ratio is a ratio of a height of the strip-shaped protrusion (13) in a first direction (X) to a width of the strip-shaped protrusion (13) in a second direction (Y), the first direction (X) is perpendicular to a plane where the substrate (20) is located, and the second direction (Y) is perpendicular to an extension direction of the strip-shaped protrusion (13) and the first direction (X).

11. The decorative substrate (100) according to any one of claims 1 to 4, wherein a height of the strip-shaped protrusion (13) in a first direction (X) is 0.1µm-20µm, a width of the strip-shaped protrusion (13) in a second direction (Y) is 1µm-150µm, the first direction (X) is perpendicular to a plane where the substrate (20) is located, and the second direction (Y) is perpendicular to an extension direction of the strip - shaped protrusion (13) and the first direction (X).

12. The decorative substrate (100) according to any one of claims 1 to 4, wherein a length of the strip-shaped protrusion (13) with the largest extension length in the grating unit (12) in an extension direction of the strip-shaped protrusion (13) is 100µm-3000µm.

13. The decorative substrate (100) according to any one of claims 1 to 4, wherein in the texture layer (10), the adjacent grating grids(11) are mirror-symmetric along an axis of symmetry (A); a distance from the grating grid (11) to the axis of symmetry (A) is less than or equal to 1/10 of a diameter (ϕ) of a circum-circle of the grating grid (11), or the distance from the grating grid(11) to the axis of symmetry (A) is less than or equal to 50µm.

14. The decorative substrate (100) according to any one of claims 1 to 4, wherein a shape of a trace of the strip-shaped protrusion (13) in a first direction comprises one or more of a straight segment and an arc segment, and the first direction is perpendicular to both the substrate (20) and an extension direction of the strip-shaped protrusion (13).

15. The decorative substrate (100) according to any one of claims 1 to 4, wherein a shape of the strip-shaped protrusion (13) in its extension direction comprises one or more of a linear-shape, a saddle-shape, a zigzag-shape, and an arc-shape.

16. The decorative substrate (100) according to any one of claims 1 to 4, wherein the decorative substrate (100) further comprises a modification layer (30), the modification layer comprises one or more of a color-developing layer, a frosted layer, and a glitter layer, and the modification layer is arranged on a surface of the texture layer (10) and/or a surface of the substrate (20).

17. The decorative substrate (100) according to any one of claims 1 to 4, wherein within the same grating unit (12), lengths of the plurality of strip-shaped protrusions (13) in an extension direction of the strip-shaped protrusion (13) gradually increase in a direction away from the central point (P); or, within the same grating unit (12), lengths of the plurality of strip-shaped protrusions (13) in an extension direction of the strip-shaped protrusion (13) first gradually increase and then gradually decrease in a direction away from the central point (P).

18. A preparation method of a decorative substrate (100), comprising following steps:
forming a texture layer (10) on a surface of a substrate (20) to obtain the decorative substrate (100), wherein preparation method of the texture layer (10) comprises one or more of transferring, etching, and hot-pressing molding; and a surface of the texture layer (10) and away from the substrate (20) is arranged with a plurality of grating grids (11); at least more than one of the grating grids (11) comprise a plurality of grating units (12) annularly arranged around a central point (P); and the grating units (12) comprise a plurality of strip-shaped protrusions (13), the plurality of strip-shaped protrusions (13) is sequentially arranged in the radial direction of a circle with the central point (P) as the center;
in the grating grid(11), the strip-shaped protrusion (13) comprises a first surface (131) close to the central point (P), a second surface (132) away from the central point (P), and a third surface (133) connected to the first surface (131) and the second surface (132); and the third surface (133) is in contact with the substrate (20), and an angle (α) formed by the first surface (131) and the third surface (133) is less than or equal to an angle (β) formed by the second surface (132) and the third surface (133).

19. A cover plate (110), comprising the decorative substrate (100) according to any one of claims 1 to 17 and a base (120), the decorative substrate (100) being arranged on the base (120).

20. An electronic device (200), comprising the cover plate (110) according to claim 19.
